# EUROPÄISCHE PATENTSCHRIFT

(11) **EP 1 174 745 B1**
(45) Veröffentlichungstag und Bekanntmachung des Hinweises auf die Patenterteilung: **24.05.2006**
(21) Anmeldenummer: 01117043.8
(22) Anmeldetag: 12.07.2001
(51) Int. Cl.: G02B 6/42

(54) **Optoelektronisches oberflächenmontierbares Modul**
Optoelectronic surface- mountable module
Module optoélectronique montable en surface

(30) Priorität: 18.07.2000 DE 10034865
(43) Veröffentlichungstag der Anmeldung: 23.01.2002
(73) Patentinhaber: Infineon Technologies AG, 81669 München (DE)
(72) Erfinder: Auberger, Albert, 93128 Regenstauf (DE); Hurt, Hans, 93049 Regensburg (DE); Reill, Joachim, 93197 Zeitlarn (DE); Weigert, Martin, 93152 Hardt (DE); Gattinger, Peter, 71522 Backnang (DE); Kuhn, Gerhard, 93096 Köfering (DE); Waidhas, Bernd, 93161 Sinzing (DE); Wicke, Markus, 93138 Lappersdorf-Einhausen (DE)
(74) Vertreter: Graf Lambsdorff, Matthias

(56) Entgegenhaltungen:
- EP-A- 0 550 973
- DE-A- 19 527 026
- DE-A- 19 755 734
- DE-A- 19 826 648
- US-A- 4 355 321
- US-A- 5 907 151
- US-A- 5 973 337
- PATENT ABSTRACTS OF JAPAN vol. 1995, no. 02, 31. März 1995 (1995-03-31) -& JP 06 310759 A (KYOCERA CORP), 4. November 1994 (1994-11-04)
- PATENT ABSTRACTS OF JAPAN vol. 017, no. 386 (E-1401), 20. Juli 1993 (1993-07-20) -& JP 05 067770 A (SONY CORP), 19. März 1993 (1993-03-19)

## Beschreibung

Die Erfindung betrifft ein optoelektronisches Modul, bei welchem ein optoelektronisches Bauelement auf einem Substrat befestigt und mit inneren elektrischen Anschlüssen des Moduls verbunden ist. Diese inneren elektrischen Anschlüssen werden durch elektrische Zuleitungen mit äußeren elektrischen Anschlüssen verbunden, welche in einer gemeinsamen Montageebene angeordnet und derart beschaffen sind, daß mit ihnen eine Oberflächenmontage des optoelektronischen Moduls auf einer bedruckten Schaltungsplatine ermöglicht wird. Die vorliegende Erfindung bezieht sich somit im allgemeinen auf das Gebiet der SMT-(Surface Mounting Technology) fähigen elektronischen und optoelektronischen Bauelemente. Insbesondere bezieht sich die vorliegende Erfindung dabei auf solche optoelektronischen SMT-fähigen Module, bei denen die äußeren elektrischen Anschlüsse durch ein Ball Grid Array (BGA), also durch eine an sich im Stand der Technik bekannte regelmäßige Anordnung von schmelzfähigen oder reflow-fähigen Höckern gebildet wird. Die vorliegende Erfindung bezieht sich dabei auf solche optoelektronischen Module, die gleichzeitig mit einer Lichtleitfaser zur Übertragung von Informations- und Datensignalen gekoppelt werden können.

Ein derartiges optoelektronisches Modul ist an sich im Stand der Technik bekannt. In der DE 196 43 072 A1 wird ein sowohl optisch als auch elektrisch ankoppelbares optoelektronisches Modul beschrieben, bei welchem der elektrische Anschluß aus Außenkontakten an einem SMD-Gehäuse und ein optischer Anschluß aus einer Steckerbuchse besteht, welche mit einem MT-Stecker kompatibel ist. Dabei können die äußeren Anschlüsse in der BGA-Technik (BGA = Ball Grid Array) ausgeführt sein. Das hier vorgeschlagene optoelektronische Bauelement ist somit mit einem Lichtwellenleiter koppelbar, dessen optische Signale in dem Bauelement in elektrische Signale umgewandelt werden. Das Ausführungsbeispiel zeigt ein in der SMD-Technik ausgebildetes Gehäuse mit äußeren elektrischen Anschlüssen, welche mit Leiterbahnen auf einer bedruckten Schaltung verlötet werden können und deren in das Gehäuse hineinragende Enden mit einer Leiterplatte verbunden sind, welche eine zum Betrieb des optischen Bauelements erforderliche elektronische Schaltung enthält. In einer Seitenwand des Gehäuses ist eine Steckerbuchse befestigt, in welcher das Ende des Lichtwellenleiters geführt ist, wobei es sich bei der Steckerbuchse um das Gegenstück zu einem MT-Stecker handelt. Die Herstellung dieses bekannten optoelektronischen Bauelements ist jedoch mit einem relativ großen Aufwand verbunden, da zum einen ein Gehäuse vorgesehen werden muß und zum anderen eine aufwendig zu fertigende Steckerbuchse in eine Seitenöffnung des Gehäuses eingesetzt werden muß, durch die der optische Anschluß für den Lichtwellenleiter gebildet wird.

Aus der DE 197 54 874 A1 sind ein Verfahren zur Umformung eines Substrats mit Randkontakten in ein Ball Grid Array, ein nach diesem Verfahren hergestelltes Ball Grid Array und eine flexible Verdrahtung zur Umformung eines Substrats mit Randkontakten in ein Ball Grid Array bekannt. Dabei erfolgt die Umformung eines Substrats mit Randkontakten in ein Ball Grid Array mit Hilfe einer flexiblen Verdrahtung, die auf der Unterseite flächig angeordnete Anschlüsse zur Aufnahme von schmelzfähigen Höckern aufweist und deren von den Anschlüssen nach außen führende Leiter freiliegende Enden besitzen. Dabei werden die freiliegenden Enden der Leiter U-förmig um die Stirnseite des Substrats gebogen und mit den Randkontakten des Substrats elektrisch leitend verbunden. Diese Druckschrift bezieht sich jedoch lediglich auf elektronische Bauelemente und nicht auf optoelektronische Lichtwellenleiterkomponenten.

Die Druckschrift US-A-4 355 321 beschreibt eine optoelektronische Anordnung, bei der das optoelektronische Bauelement auf einem Substrat aufgebracht ist, welches aus einem für die Wellenlänge transparenten, einkristallinen HalbleiterMaterial mit relativ hohem Brechungsindex hergestellt ist.

Das Substrat ist mit zwei elektrischen Anschlußflächen kontaktiert, zwischen denen eine Öffnung für den Durchtritt der Lichtstrahlung gebildet ist und in die das Ende einer Lichtleitfaser eingebracht ist. Die ersten elektrisch leitenden Anschlußflächen sind durch säulenförmige Isolatoren auf zweite elektrische Anschlußflächen derart montiert, daß die Lichtleitfaser von den zweiten Anschlußflächen weggerichtet ist. Während also das optoelektronischeBauelement mit einer seiner Anschlußseiten über das Substrat mit den ersten elektrischen Anschlußflächen verbunden ist, ist seine andere Anschlußseite über einen Bonddraht mit einer der zweiten Anschlußflächen verbunden.

Die Druckschrift US 5,907,151 beschreibt einen optoelektronischen Wandler mit einem strahlungsaussendenden und/oder -empfangenden Halbleiter-Chip, der auf einer Trägereinheit befestigt ist. Die Trägereinheit weist einen Chip-Montagebereich auf, dem eine Anzahl von Anschlußteilen zugeordnet sind. Diese Anschlußteile sind mit elektrischen Anschlußflächen versehen, die eine Ebene definieren, deren Abstand zum Chip-Montagebereich größer ist als die maximale Höhe des Halbleiter-Chips.

Es ist somit Aufgabe der vorliegenden Erfindung, ein optoelektronisches oberflächenmontierbares Modul anzugeben, welches einfacher in der Herstellung ist und bei welchem insbesondere die Ankopplung an einen Lichtwellenleiter auf weniger aufwendige Art bewirkt werden kann.

Diese Aufgabe wird mit den Merkmalen der unabhängigen Patentansprüche gelöst. Vorteilhafte Weiterbildungen und besondere Ausführungsformen sind in den Unteransprüchen dargestellt.

Die vorliegende Erfindung bezieht sich auf ein optoelektronisches oberflächenmontierbares Modul nach den Merkmalen des Patentanspruchs.

In einer ersten Ausführungsform können die äußeren elektrischen Anschlüsse in BGA-Technik (BGA = Ball Grid Array) ausgeführt und somit insbesondere aus schmelzfähigen Höckern gebildet sein, die mit den elektrischen Zuleitungen verbunden sind, wobei die Lichtein- und/oder Lichtaustrittsöffnung durch den Zwischenraum zwischen zwei Höckern definiert ist.

In einer zweiten Ausführungsform können die äußeren elektrischen Anschlüsse durch ein Leadframe gebildet sein, wobei die Lichtein- und/oder Lichtaustrittsöffnung durch eine Durchgangsöffnung des Leadframes gebildet ist.

Die Erfindung hat somit den großen Vorteil, daß ein optoelektronisches Modul nicht in aufwendiger Weise mit einem Gehäuse, einer seitlichen Gehäuseöffnung und einer darin zu formenden Steckerbuchse geformt werden muß. Vielmehr ist die Herstellung eines erfindungsgemäßen Moduls darauf ausgerichtet, zwischen äußeren elektrischen Kontaktabschnitten eine Lichtein- oder Lichtaustrittsöffnung zu bilden, durch die ein Strahlungsbündel in eine angekoppelte Lichtleitfaser eingeführt oder ein aus einer Lichtleitfaser empfangenes Strahlungsbündel in das Modul eingeführt werden kann.
Das erfindungsgemäße optoelektronische Modul kann durch Zusammenbau mit einer Schaltungsplatine zu einer optoelektronischen Kopplungseinheit zusammengesetzt werden. Eine mit elektrischen Anschlüssen und Zuleitungen bedruckte Schaltungsplatine weist beispielsweise zu diesem Zweck eine Durchgangsöffnung auf, auf deren dem Modul abgewandter Seite ein Lichtleiter ankoppelbar ist. Das Modul kann beispielsweise mit dem in der SMT-Technik bekannten Reflow-Verfahren auf die bedruckte Schaltungsplatine aufgelötet werden.

Es ist jedoch ebenfalls eine optoelektronische Kopplungseinheit mit einer Schaltungsplatine denkbar, in welcher die Lichtleitung in einer optisch leitenden Schicht stattfindet, die in der Platine stattfindet. Die Lichteinkopplung kann in diesem Fall über Öffnungen stattfinden, die dieses optische Material freilegen. Diese Öffnungen sind dann keine Durchgangsöffnungen mehr wie in dem oben genannten Beispiel einer Schaltungsplatine.

Bei der Herstellung des Moduls nach dem ersten Ausführungsbeispiel der Erfindung werden nach dem Aufbringen der inneren elektrischen Anschlüsse und des optoelektronischen Bauelements und dessen Kontaktierung, gegebenenfalls mit einem Bonddraht, die flexiblen elektrischen Zuleitungen aufgebracht und um die Seitenflächen des Substrats zu der der ersten Hauptoberfläche gegenüberliegenden zweiten Hauptoberfläche des Substrats gebogen, und dort befestigt, worauf die äußeren elektrischen Anschlüsse aufgebracht werden. Anschließend kann das Modul noch mit einer geeigneten Kunststoffumspritzung umgeben werden.

Das optoelektronische Bauelement kann beispielsweise direkt auf einem der inneren elektrischen Anschlüsse befestigt sein und an einer Seite überstehen, so daß Lichtstrahlung durch das transparente Substrat von der Lichtleitfaser zu dem optoelektronischen Bauelement und umgekehrt gelangen kann. Der Zwischenraum zwischen dem optoelektronischen Bauelement und dem Substrat kann mit einer transparenten Vergußmasse aufgefüllt werden.

In folgenden wird die vorliegende Erfindung anhand von Ausführungsbeispielen in Verbindung mit den Zeichnungsfiguren näher erläutert.

Es zeigen:
Fig. 1 ein erstes Ausführungsbeispiel für ein optoelektronisches oberflächenmontierbares Modul;
Fig.2 ein zweites Ausführungsbeispiel für ein optoelektronisches oberflächenmontierbares Modul.

Das optoelektronische Modul ist in den Figuren jeweils in einer Querschnittsdarstellung entlang einer durch das Substrat, die Zuführungen, die äußeren elektrischen Anschlüsse und die bedruckte Schaltungsplatine verlaufenden Ebene dargestellt.

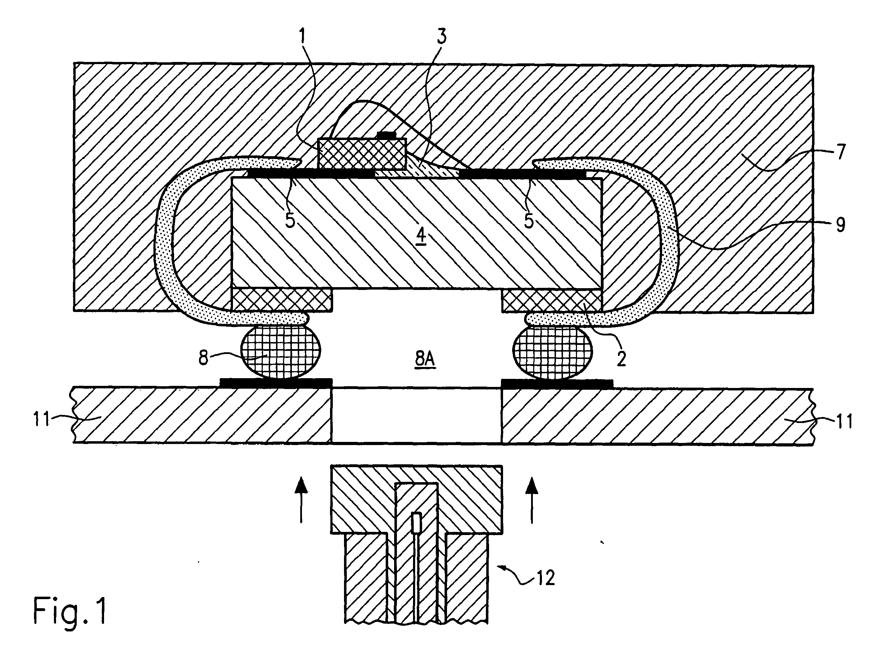

Das in der Fig. 1 dargestellte erste Ausführungsbeispiel der Erfindung weist ein Substrat 4 auf, welches für mindestens eine der von dem optoelektronischen Bauelement nutzbaren Wellenlängen transparent ist. Die zu verwendenden Wellenlängen sind entweder Emissionswellenlängen eines optoelektronischen Bauelements 1, welches ein Sender wie eine Laserdiode ist, oder Empfangswellenlängen für ein als Empfangsbauelement verwendetes optoelektronisches Bauelement 1 wie eine PIN-Photodiode. Auf dem Substrat 4 kann ein einzelnes Bauelement 1 oder auch mehrere optoelektronische Bauelemente auf die weiter unten beschriebene Weise montiert werden. In dem gezeigten Ausführungsbeispiel ist lediglich ein einzelnes optoelektronisches Bauelement 1 dargestellt, wodurch jedoch die Erfindung nicht auf diesen Fall beschränkt werden soll.

Auf die erste Hauptoberfläche des Substrats 4 werden zunächst innere elektrische Anschlüsse 5 aufgebracht, an die das optoelektronische Bauelement 1 elektrisch angeschlossen werden soll. Auf einen dieser flächigen Anschlüsse 5 wird dann das optoelektronische Bauelement 1 montiert. Das optoelektronische Bauelement 1 wird derart auf den Anschluß 5 aufgebracht, daß empfangene Lichtstrahlung durch das transparente Substrat 4 zu dem optoelektronischen Bauelement 1 gelangen kann und gleichermaßen von dem optoelektronischen Bauelement 1 emittiertes Licht durch das transparente Substrat 4 in einen angekoppelten Lichtwellenleiter 12 eingekoppelt werden kann. Der Raum zwischen dem optoelektronischen Bauelement 1 und dem Substrat 4 kann gegebenenfalls mit einer transparenten Vergußmasse 3 ausgefüllt werden. Auf die inneren elektrischen Anschlüsse 5 werden flexible Zuleitungen 9 aufgebracht und U-förmig um die Seitenflächen des Substrats 4 zu der zweiten Hauptoberfläche gebogen und dort gegebenenfalls unter Verwendung von isolierenden Abstandshaltern 2 an dem Substrat 4 befestigt. Die Abstandshalter 2 können beispielsweise aus einer Silikon-Polymer-Mischung bestehen. Auf die Unterseite der elektrischen Zuleitungen 9 werden dann äußere elektrische Anschlüsse 8, vorzugsweise in Form von schmelzfähigen Höckern als Ball Grid Array (BGA) aufgebracht. Durch den Zwischenraum zwischen zwei oder mehr äußeren elektrischen Anschlüssen 8 wird eine Lichtein- oder Lichtaustrittsöffnung 8A des Moduls definiert.

In dem beschriebenen Ausführungsbeispiel werden die Zuleitungen 9 U-förmig um die Seitenflächen des Substrats 4 auf dessen gegenüberliegende Hauptoberfläche gebogen. Alternativ dazu können die elektrischen Zuleitungen 9 auch bei Verwendung eines ausreichend elektrisch isolierenden Substrats 4 entlang von Durchgangsbohrungen von einer Hauptoberfläche zur gegenüberliegenden Hauptoberfläche geführt werden.

Das Modul kann in SMT-Technik auf eine bedruckte Schaltungsplatine 11 aufgelötet werden, welche elektrische Anschlüsse und elektrische Zuleitungen in aufgedruckter Form aufweist. Dargestellt sind lediglich aufgedruckte elektrische Anschlußflächen der Schaltungsplatine 11, auf welche die äußeren elektrischen Anschlüsse 8 des Moduls aufgesetzt und anschließend beispielsweise mittels des in der SMT-Technik bekannten Reflow-Verfahrens aufgelötet werden. Die Schaltungsplatine 11 weist eine Durchgangsöffnung auf, durch die Licht in einen angeschlossenen Lichtwellenleiter 12 eingekoppelt und von dem Lichtwellenleiter 12 empfangenes Licht in Richtung auf das Modul gelenkt werden kann.
Bei der Herstellung des Moduls kann im Anschluß an das Umbiegen der elektrischen Zuleitungen 9 und das Aufbringen der äußeren Anschlüsse 8 noch ein Formkörper 7 aus einem geeigneten Kunststoff zum Schutz des Moduls vor äußeren Beeinträchtigungen angespritzt oder angeformt werden.

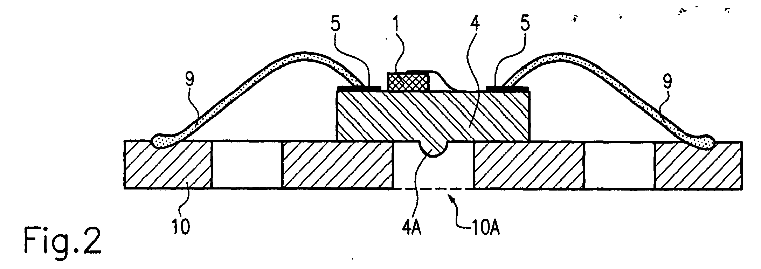

Für die mit gleichen Bezugszeichen versehenen Elemente der in den Figuren 2 und 3 dargestellten Ausführungsbeispiele gelten die gleichen Feststellungen wie die für das erste Ausführungsbeispiel getroffenen.

Bei dem in der Fig.2 dargestellten zweiten Ausführungsbeispiel sind die äußeren elektrischen Anschlüsse als die Anschlußabschnitte eines Leiterrahmens oder Leadframes 10 ausgebildet. Der Leadframe wird auf der zweiten Hauptoberfläche des Substrats 4 befestigt und eine Durchgangsöffnung 10A des Leadframes 10 bildet die Lichtein- oder Lichtaustrittsöffnung des Moduls. Die Zuleitungen 9 werden in diesem Fall lediglich von den inneren elektrischen Anschlüssen 5 an der ersten Hauptoberfläche des Substrats 4 zu oberen Oberflächen von Leadframe-Anschlußabschnitten geführt. In die zweite Hauptoberfläche des Substrats 4 kann eine Linse 4A integriert sein, durch die Licht in eine angekoppelte Lichtleitfaser (nicht dargestellt) eingekoppelt oder aus einer Lichtleitfaser empfangenes Licht parallelisiert werden kann. Auch das Modul gemäß dem zweiten Ausführungsbeispiel kann wie oben beschrieben mit einer Schaltungsplatine (nicht dargestellt) verbunden werden.

## Patentansprüche

1. Optoelektronisches oberflächenmontierbares Modul, mit
- einem optoelektronischen Bauelement (1),
- einem Substrat (4), das für mindestens eine der von dem optoelektronischen Bauelement (1) nutzbaren Wellenlängen transparent ist und auf dessen erster Hauptoberfläche das optoelektronische Bauelement (1) derart montiert ist, dass empfangene Lichtstrahlung durch das Substrat (4) zu dem optoelektronischen Bauelement (1) gelangt oder von dem optoelektronischen Bauelement (1) emittierte Lichtstrahlung durch das Substrat (4) austritt,
- zwei inneren elektrischen Anschlüssen (5), die auf der ersten Hauptoberfläche des Substrats (4) aufgebracht sind, wobei je ein innerer elektrischer Anschluss (5) mit einem der beiden Anschlüsse des optoelektronischen Bauelements (1) verbunden ist,
**gekennzeichnet durch**
- zwei äußere elektrische Anschlüsse (8; 10; 21), die mit der der ersten Hauptoberfläche gegenüberliegenden zweiten Hauptoberfläche des Substrats (4) verbunden sind, wobei je ein äußerer Anschluss (8; 10; 21) mit einem inneren elektrischen Anschluss (5) **durch** eine elektrische Zuleitung (9) verbunden ist, wobei
- **durch** die Anordnung und/oder Beschaffenheit der äußeren elektrischen Anschlüsse (8; 10; 21) eine Lichtein- und/oder Lichtaustrittsöffnung (8A; 10A; 20A) gegenüber dem optoelektronischen Bauelement (1) definiert ist.

2. Optoelektronisches Modul nach Anspruch 1,
**dadurch gekennzeichnet, daß**
- die äußeren elektrischen Anschlüsse (8) in BGA-Technik (BGA = Ball Grid Array) ausgeführt sind und somit insbesondere aus schmelzfähigen Höckern (8) gebildet sind, die mit den Zuleitungen (9) verbunden sind, und
- die Lichtein- und/oder Lichtaustrittsöffnung durch den Zwischenraum (8A) zwischen zwei Höckern (9) definiert ist.

3. Optoelektronisches Modul nach Anspruch 1 oder 2,
**dadurch gekennzeichnet, daß**
- die zwischen den Hauptoberflächen verlaufenden Zuleitungen (9) U-förmig um die Seitenflächen des Substrats (4) gebogen sind.

4. Optoelektronisches Modul nach Anspruch 1,
**dadurch gekennzeichnet, daß**
- die äußeren elektrischen Anschlüsse durch ein Leadframe (10) gebildet sind, und
- die Lichtein- und/oder Lichtaustrittsöffnung durch eine Durchgangsöffnung (10A) des Leadframes (10) gebildet ist.

5. Optoelektronisches Modul nach einem der vorhergehenden Ansprüche,
**dadurch gekennzeichnet, daß**
- das Substrat (4) aus Silizium gebildet ist.

6. Optoelektronisches Modul nach einem der vorhergehenden Ansprüche,
**dadurch gekennzeichnet, daß**
- in die zweite Hauptoberfläche des Substrats (4) eine Linse (4A) integriert ist.

7. Optoelektronische Kopplungseinheit, mit
- einem optoelektronischen Modul gemäß einem der vorhergehenden Ansprüche, welches
- mit einer bedruckten Schaltungsplatine (11) elektrisch verbunden ist, welche eine mit der Lichtein- oder Lichtaustrittsöffnung fluchtende Durchgangsöffnung aufweist, auf deren dem Modul abgewandten Seite ein Lichtwellenleiter (12) ankoppelbar ist.

8. Optoelektronische Kopplungseinheit, mit
- einem optoelektronischen Modul gemäß einem der vorhergehenden Ansprüche, welches
- mit einer bedruckten Schaltungsplatine elektrisch verbunden ist, in welcher eine optisch leitende Schicht angeordnet ist, wobei die Lichtein- und -auskopplung in die und aus der optisch leitenden Schicht über Öffnungen der Schaltungsplatine stattfindet, die das Material der optisch leitenden Schicht freilegen.

## Claims

1. Optoelectronic surface-mountable module, having
- an optoelectronic component (1),
- a substrate (4) which is transparent to at least one of the wavelengths which can be utilized by the optoelectronic component (1) and on the first main surface of which the optoelectronic component (1) is mounted in such a way that received light radiation passes through the substrate (4) to the optoelectronic component (1) or light radiation emitted by the optoelectronic component (1) emerges through the substrate (4),
- two internal electrical connections (5), which are applied on the first main surface of the substrate (4), a respective internal electrical connection (5) being connected to one of the two connections of the optoelectronic component (1),
**characterized by**
- two external electrical connections (8; 10; 21), which are connected to the second main surface of the substrate (4), said main surface being opposite to the first main surface, a respective external connection (8; 10; 21) being connected to an internal electrical connection (5) by an electrical lead (9),
- a light entry opening and/or light exit opening (8A; 10A; 20A) relative to the optoelectronic component (1) being defined by the arrangement and/or configuration of the external electrical connections (8; 10; 21).

2. Optoelectronic module according to Claim 1, **characterized in that**,
- the external electrical connections (8) are embodied using BGA technology (BGA= ball grid array) and are thus formed, in particular, from fusible bumps (8) which are connected to the leads (9), and
- the light entry opening and/or light exit opening is defined by the interspace (8A) between two bumps (8).

3. Optoelectronic module according to Claim 1 or 2,
**characterized in that**,
- the leads (9) running between the main surfaces are bent in a U-shaped manner around the side areas of the substrate (4).

4. Optoelectronic module according to Claim 1, **characterized in that**,
- the external electrical connections are formed by a lead frame (10), and
- the light entry opening and/or exit opening is formed by a through opening (10A) of the lead frame (10).

5. Optoelectronic module according to one of the preceding claims, **characterized in that**,
- the substrate (4) is formed from silicon.

6. Optoelectronic module according to one of the preceding claims, **characterized in that**,
- a lens (4A) is integrated into the second main surface of the substrate (4).

7. Optoelectronic coupling unit, having
- an optoelectronic module as claimed in one of the preceding claims, which
- is electrically connected to a printed circuit board (11) having a through opening which is aligned with the light entry opening or light exit opening and on whose side remote from the module an optical waveguide (12) can be coupled.

8. An optoelectronic coupling unit, having
- an optoelectronic module as claimed in one of the preceding claims, which
- is electrically connected to a printed circuit board in which an optically conducting layer is arranged, the coupling of light into and out of the optically conducting layer taking place via openings in the circuit board which uncover the material of the optically conducting layer.

## Revendications

1. Module optoélectronique pouvant être monté en surface comprenant
- un composant (1) optoélectronique,
- un substrat qui est transparent à au moins l'une des longueurs d'ondes qui peuvent être utilisées par le composant (1) optoélectronique et sur la première surface principale duquel est monté un composant (1) optoélectronique, de façon à ce que du rayonnement lumineux reçu arrive en passant à travers le substrat (4) au composant (1) optoélectronique ou que du rayonnement lumineux émis par le composant (1) optoélectronique sorte en passant à travers le substrat (4),
- deux bornes (5) électriques intérieures qui sont déposées sur la première surface principale du substrat (4), chaque borne (5) électrique intérieure étant reliée à l'une des deux bornes du composant (1) optoélectronique,
**caractérisé par**
- deux bornes (8 ; 10 ; 21) électriques extérieures qui sont reliées à la deuxième surface principale du substrat (4) opposée à la première surface principale, chaque borne (8 ; 10 ; 21) extérieure étant reliée à une borne (5) électrique intérieure par une ligne (9) électrique d'entrée, dans lequel
- par l'agencement et/ou la propriété des bornes (8 ; 10 ; 21) électriques extérieures, une ouverture (8A ; 10A ; 20A) d'entrée de lumière et/ou de sortie de lumière est définie en face du composant (1) optoélectronique.

2. Module optoélectronique suivant la revendication 1,
**caractérisé en ce que**
- les bornes (8) électriques extérieures sont réalisées en technique BGA (BGA = Ball Grid Array) et sont ainsi formées notamment de bossages (8) fusibles qui sont reliés aux lignes (9) d'entrée, et
- l'ouverture d'entrée de la lumière et/ou de sortie de la lumière est définie par l'espace (8A) intermédiaire entre deux bossages (9).

3. Module optoélectronique suivant la revendication 1 ou 2,
**caractérisé en ce que**
- les lignes (9) d'entrée s'étendant entre les surfaces principales sont recourbées en forme de U autour des faces latérale du substrat (4).

4. Module optoélectronique suivant la revendication 1,
**caractérisé en ce que**
- les bornes électriques extérieures sont formées par un leadframe (10), et
- l'ouverture d'entrée de la lumière et/ou de sortie de la lumière est formée par une ouverture (10A) de traversée du leadframe (10).

5. Module optoélectronique suivant l'une des revendications précédentes,
**caractérisé en ce que**
- le substrat (4) est en silicium.

6. Module optoélectronique suivant l'une des revendications précédentes,
**caractérisé en ce que**
- une lentille (4A) est intégrée dans la deuxième surface principale du substrat (4).

7. Unité de couplage optoélectronique comprenant
- un module optoélectronique suivant l'une des revendications précédentes qui
- est relié électriquement à une platine (11) de circuit imprimé, qui a une ouverture de traversée qui est alignée avec l'ouverture d'entrée de la lumière ou de sortie de la lumière et, du côté, éloigné du module, de laquelle peut être couplé un guide d'onde lumineuse (12).

8. Unité de couplage optoélectronique comprenant
- un module optoélectronique suivant l'une des revendications précédentes qui
- est relié électriquement à une platine de circuit imprimé dans laquelle est disposée une couche conductrice du point de vue optique, l'entrée et/ou la sortie de lumière dans la couche conductrice du point de vue optique et hors de celle-ci ayant lieu par des ouvertures de la platine de circuit, qui mettent à nu la matière de la couche conductrice du point de vue optique.
